# EUROPEAN PATENT APPLICATION

(11) **EP 4 439 096 A1**
(43) Date of publication of application: **02.10.2024**
(21) Application number: 22932306.8
(22) Date of filing: 18.11.2022
(51) Int. Cl.: G01R 31/28, G01R 31/26

(54) **COOLING UNIT, OBJECTIVE LENS MODULE, AND SEMICONDUCTOR INSPECTION APPARATUS**

(30) Priority: 17.03.2022 JP 2022042839
(71) Applicant: Hamamatsu Photonics K.K., Hamamatsu-shi, Shizuoka 435-8558 (JP)
(72) Inventor: NAKAMURA Akihiro, Hamamatsu-shi, Shizuoka 435-8558 (JP)
(74) Representative: Grünecker Patent- und Rechtsanwälte PartG mbB
(86) International application number: PCT/JP2022/042856
(87) International publication number: WO 2023/176043

(57) **Abstract**

A cooling unit includes a jacket, and the jacket includes a central portion and an outer portion. An opening through which light from a semiconductor device passes is formed in the central portion. The outer portion includes a contact portion that comes into contact with a stage on which the semiconductor device is disposed. A supply flow passage through which a cooling fluid for cooling the semiconductor device flows is formed in the jacket. A groove configured so that the cooling fluid flows down from an upper surface of the central portion is formed between the central portion and the outer portion in the jacket. A discharge flow passage through which the cooling fluid to be discharged to the outside flows is connected to the groove.

## Description

### Technical Field

The present disclosure relates to a cooling unit, an objective lens module, and a semiconductor testing device.

### Background Art

Patent Literatures 1 to 4 describe cooling units that are used in a semiconductor device test. These cooling units are used for observation while cooling down a semiconductor device in operation. In the cooling units described in Patent Literatures 1 to 3, the semiconductor device is cooled down by injecting a cooling liquid to the semiconductor device. In a cooling unit described in Patent Literature 4, the cooling unit is disposed so that a space is formed between the cooling unit and the semiconductor device, and a cooling fluid is caused to flow into the space from a supply flow passage provided in the cooling unit, thereby cooling down the semiconductor device.

### Citation List

### Patent Literature

Patent Literature 1: U.S. Patent No. 6621275
Patent Literature 2: Japanese Unexamined Patent Publication No. 2006-519359
Patent Literature 3: U.S. Patent Publication No. 2009-0095097
Patent Literature 4: Japanese Unexamined Patent Publication No. 2020-106361

### Summary of Invention

### Technical Problem

In the cooling unit described in Patent Literature 4, an elastic member is disposed on a peripheral edge portion of the cooling unit, and when the elastic member comes into contact with a stage on which the semiconductor device is disposed, an outer edge portion of the above-described space is sealed. In the cooling unit, it is demanded to improve a waterproof performance, and to suppress a cooling fluid from being leaked from the outer edge portion of the space.

Here, an object of an aspect of the present disclosure is to provide a cooling unit, an objective lens module, and a semiconductor test device which are capable of improving a waterproof performance.

### Solution to Problem

A cooling unit according to an aspect of the present disclosure is a cooling unit for using in a semiconductor device test. The cooling unit includes a jacket configured to dissipate heat of the semiconductor device. The jacket includes a central portion, and an outer portion located around the central portion, an opening through which light from the semiconductor device passes is formed in the central portion, the outer portion includes a contact portion that comes into contact with a stage on which the semiconductor device is disposed, a supply flow passage through which a cooling fluid for cooling the semiconductor device flows is formed in the jacket, a groove configured so that the cooling fluid flows down from an upper surface of the central portion is formed between the central portion and the outer portion in the jacket, and a discharge flow passage through which the cooling fluid to be discharged to an outside flows is connected to the groove.

In the cooling unit, the groove configured so that the cooling fluid flows down from the upper surface of the central portion is formed between the central portion and the outer portion in the jacket, and the discharge flow passage through which the cooling fluid to be discharged to the outside flows is connected to the groove. According to this, in a case of cooling the semiconductor device by flowing the cooling fluid from the supply flow passage to a space that is formed when the contact portion of the outer portion comes into contact with the stage, it is possible to suppress the cooling fluid from reaching an outer edge portion of the space. As a result, it is possible to suppress the cooling fluid from being leaked from the outer edge portion of the space, and it is possible to improve a waterproof performance.

A bridge portion connecting the central portion and the outer portion to each other may be formed between the central portion and the outer portion in the jacket, and the supply flow passage may be formed to pass through the bridge portion. In this case, it is possible to appropriately form the supply flow passage.

A bridge portion connecting the central portion and the outer portion to each other may be formed between the central portion and the outer portion in the jacket, and a surface connected to the upper surface of the central portion in the bridge portion may include a portion located at a position lower than the upper surface of the central portion. In this case, when the surface connected to the upper surface of the central portion in the bridge portion includes a portion located at a position lower than the upper surface of the central portion, it is possible to suppress the cooling fluid from reaching the outer edge portion of the space from the upper surface of the central portion along the surface.

The groove may include a first portion, and a second portion located on a side opposite to the upper surface of the central portion with respect to the first portion in a direction orthogonal to the upper surface of the central portion, the second portion may be formed to be narrower than the first portion, and the discharge flow passage may be connected to the second portion. In this case, it is possible to increase a passage area of the groove by widening the first portion located on the upper surface side of the central portion, and the cooling fluid is likely to flow into the groove. In addition, when narrowing the second portion located on a side opposite to the upper surface of the central portion, the cooling fluid is likely to be stored in the second portion, and as a result, it is possible to efficiently discharge the cooling fluid from the discharge flow passage connected to the second portion.

When a side where the central portion is located with respect to the outer portion is set as an inner side, a side where the outer portion is located with respect to the central portion is set as an outer side, and a side where the groove is located with respect to the upper surface of the central portion is set as a lower side, an inner surface of the outer side in the groove may include an inclined surface inclined to face the inner side as going toward the lower side. In this case, it is possible to increase the volume of the groove, and it is possible to appropriately flow the cooling fluid flown into the groove to a lower side.

The groove may include a ring-shaped portion surrounding the upper surface when viewed from a direction orthogonal to the upper surface of the central portion. In this case, it is possible to efficiently store the cooling fluid in the groove, and it is possible to efficiently discharge the stored cooling fluid to the outside.

A ventilation route configured to connect the space to an outside of the jacket so that air circulation between a space formed when the contact portion comes into contact with the stage and the outside of the jacket is possible may be formed in the jacket, and the ventilation route may be connected to the groove. In this case, it is possible to suppress a pressure inside the space from being a negative pressure. Therefore, when moving the cooling unit along the stage on which the semiconductor device is disposed while flowing the cooling fluid, it is possible to avoid occurrence of a situation in which the cooling unit sticks to the stage due to the negative pressure, and thus the cooling unit cannot be moved, and movement accuracy deteriorates. As a result, it is possible to move the cooling unit with accuracy while flowing the cooling fluid.

An objective lens module according to another aspect of the present disclosure includes the cooling unit, an immersion lens disposed in the opening, and an objective lens facing the immersion lens. According to the objective lens module, it is possible to improve the waterproof performance due to the above-described reason.

A semiconductor test device according to still another aspect of the present disclosure includes the cooling unit, an immersion lens disposed in the opening, a stage on which the semiconductor device is disposed, an objective lens facing the immersion lens, and a photodetector configured to detect light from the semiconductor device through the immersion lens and the objective lens. According to the semiconductor test device, it is possible to improve the waterproof performance due to the above-described reason.

### Advantageous Effects of Invention

According to the aspect of the present disclosure, it is possible to provide a cooling unit, an objective lens module, and a semiconductor test device which are capable of improving a waterproof performance.

### Brief Description of Drawings

[FIG. 1] FIG. 1 is a configuration diagram of a semiconductor testing device according to an embodiment.
[FIG. 2] FIG. 2 is a cross-sectional view of the periphery of an objective lens module.
[FIG. 3] FIG. 3 is a plan view of the objective lens module.
[FIG. 4] FIG. 4 is a cross-sectional view of a cooling unit along line IV-IV in FIG. 3, and is a partially enlarged view of FIG. 2.
[FIG. 5] FIG. 5 is a cross-sectional view of the cooling unit along line V-V in FIG. 3.
[FIG. 6] FIG. 6 is a partially enlarged view of FIG. 5.
[FIG. 7] FIG. 7 is a cross-sectional view of the cooling unit along line VII-VII in FIG. 3.
[FIG. 8] FIG. 8 is a partially enlarged view of FIG. 7.
[FIG. 9] FIG. 9 is a perspective view of the objective lens module.
[FIG. 10] FIG. 10 is an exploded perspective view of a ventilation member.
[FIG. 11] FIGS. 11(a) and 11(b) are views describing an operation of the objective lens module according to an embodiment.
[FIG. 12] FIGS. 12(a) and 12(b) are views describing the operation of the objective lens module according to the embodiment.
[FIG. 13] FIGS. 13(a) and 13(b) are views describing an operation of an objective lens module according to a first modification example.
[FIG. 14] FIGS. 14(a) and 14(b) are views describing the operation of the objective lens module according to the first modification example.
[FIG. 15] FIG. 15 is a plan view of an objective lens module according to a second modification example.

### Description of Embodiments

Hereinafter, an embodiment of the present disclosure will be described in detail with reference to the drawings. In the following description, the same reference numeral will be given to the same or equivalent element, and redundant description will be omitted.

### [Semiconductor Testing Device]

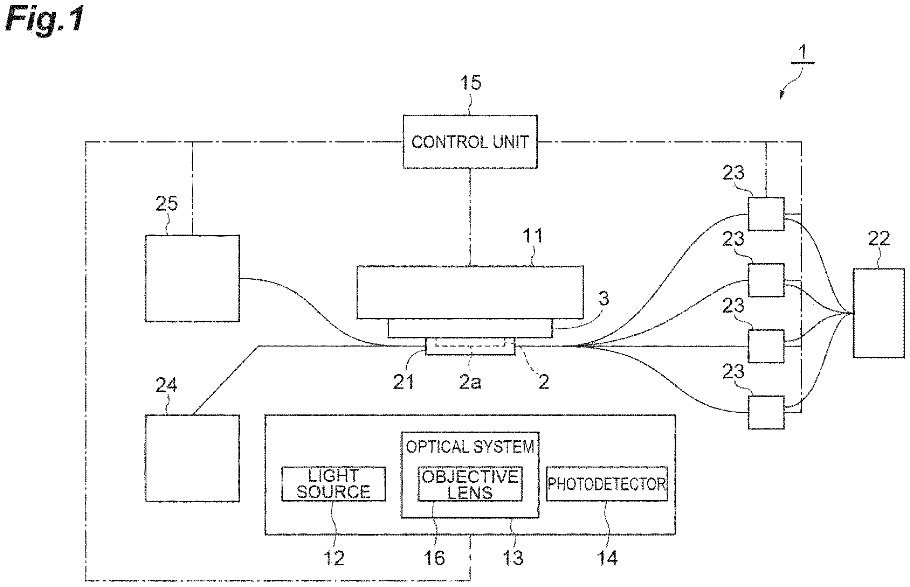

A semiconductor testing device 1 illustrated in FIG. 1 is a device that observes a semiconductor device 2 that is a device under test (DUT) for testing. For example, the semiconductor testing device 1 is used to specify a failure location in the semiconductor device 2.

For example, the semiconductor device 2 is a device including a logic large scale integration (logic LSI). The logic LSI is constituted by a transistor having a metal-oxide-semiconductor (MOS) structure, a transistor having a bipolar structure, or the like. Power consumption of the semiconductor device 2 is, for example, approximately 200 W. The semiconductor device 2 is disposed on (fixed to) a stage 3.

The semiconductor testing device 1 includes a signal input device 11, a light source 12, an optical system 13, a photodetector 14, and a control unit 15. The signal input device 11 is electrically connected to the semiconductor device 2, and inputs a signal to the semiconductor device 2 to drive the semiconductor device 2. Examples of the signal input device 11 include a pulse generator that applies a stimulation signal to the semiconductor device 2, a tester unit that inputs a test signal to the semiconductor device 2, and the like. The signal input device 11 repetitively inputs a signal such as a predetermined test pattern to the semiconductor device 2. The signal that is input by the signal input device 11 may be a modulation voltage signal, or a DC voltage signal.

The light source 12 outputs light for illumination of the semiconductor device 2. Examples of the light source 12 include a light emitting diode (LED), a laser diode (LD), a super luminescent diode (SLD), a lamp light source, and the like. A wavelength of light output from the light source 12 may be, for example, 1064 nm or longer. The light output from the light source 12 is guided to the optical system 13.

The optical system 13 guides the light output from the light source 12 to a surface 2a of the semiconductor device 2, and guides light from the surface 2a of the semiconductor device 2 to the photodetector 14. For example, the optical system 13 is configured to include an objective lens 16, an optical scanner (not illustrated), and a beam splitter (not illustrated). The objective lens 16 condenses light that is output from the light source 12 and is guided by the beam splitter and the optical scanner to an observation area or scans an observation area with the light. The optical system 13 is mounted, for example, on an XYZ stage (not illustrated). When a direction parallel to an optical axis of the objective lens 16 is set as a Z-direction, the XYZ stage is configured to be movable in the Z-direction, and an X-direction and a Y-direction orthogonal to the Z-direction. The observation area is determined depending on a position of the XYZ stage.

Light that is output from the light source 12 and is emitted from the optical system 13 is reflected by the semiconductor device 2 that is being driven and is incident to the photodetector 14 through the optical system 13. At this time, the intensity of the light reflected by the semiconductor device 2 is modulated in accordance with a driving state of the semiconductor device 2.

The photodetector 14 detects the light modulated by the semiconductor device 2 and outputs waveform data. The photodetector 14 may detect incident light while the semiconductor device 2 is being scanned with light by an optical scanner, and may output a measured image. A failure location in the semiconductor device 2 can be specified on the basis of the waveform data and the measured image.

The photodetector 14 may detect incident light while the semiconductor device 2 is scanned with light, and may output a pattern image. The pattern image is an image captured so that a circuit pattern of the semiconductor device 2, or the like can be confirmed. As the photodetector 14, for example, a photodiode, an avalanche photodiode (APD), a silicon photomultiplier (SiPM), and the like capable of detecting light with a wavelength that is transmitted through a substrate of the semiconductor device 2 can be used.

The control unit 15 is electrically connected to the signal input device 11, the light source 12, the optical system 13, the photodetector 14, and the like, and performs control of the entirety of the semiconductor testing device 1. For example, the control unit 15 is constituted by a computer including a processor (central processing unit (CPU)), a storage medium such as a random access memory (RAM), a read only memory (ROM), and a hard disk drive (HDD), and the like. The control unit 15 executes processing by the processor on data stored in the storage medium. For example, the control unit 15 performs specific processing on a failure location in the semiconductor device 2 on the basis of a detection result of the photodetector 14.

### [Configuration for Cooling Semiconductor Device]

The semiconductor testing device 1 further includes a cooling unit 21, a storage tank 22, four regulators (pressure adjustment units) 23, a drain tank 24, and a chiller 25. The cooling unit 21, the storage tank 22, the regulators 23, the drain tank 24, and the chiller 25 are used so as to cool down the semiconductor device 2 during the test. The cooling unit 21 constitutes an objective lens module 70 in combination with the objective lens 16.

### [Cooling Unit]

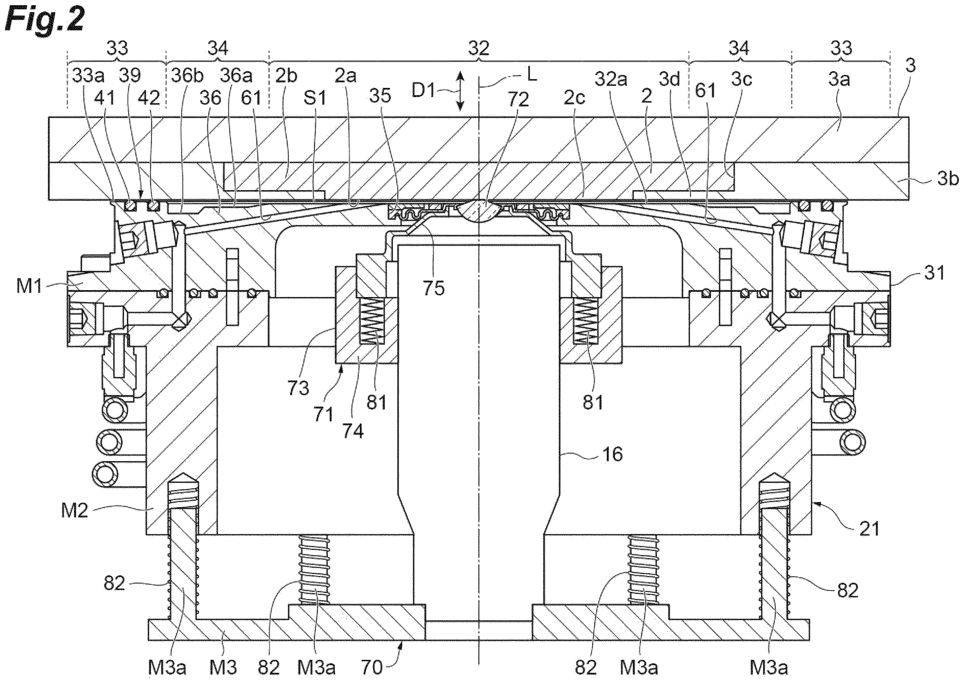

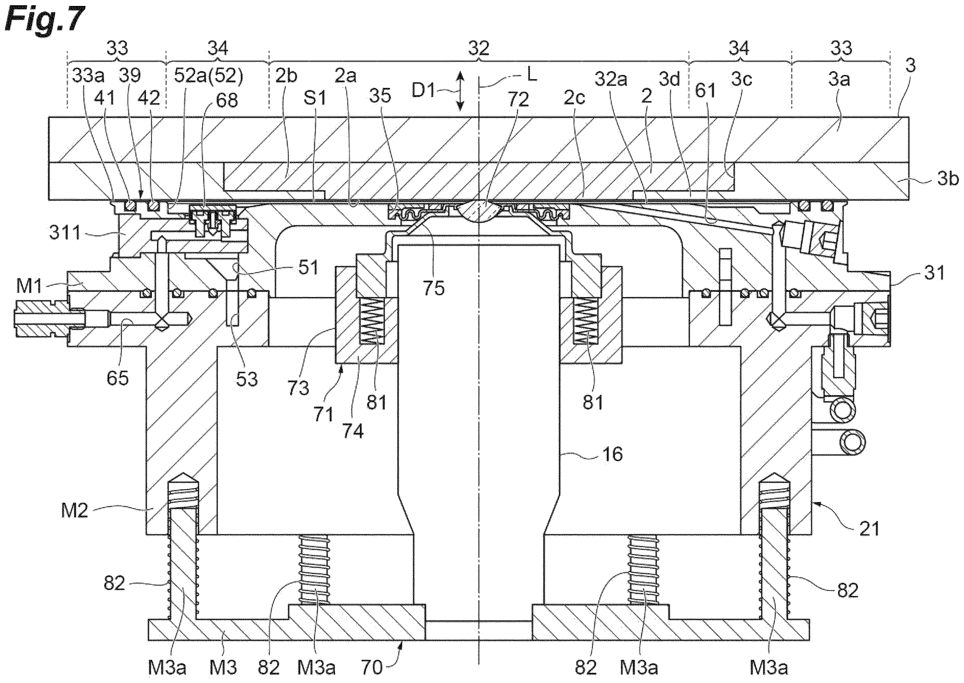

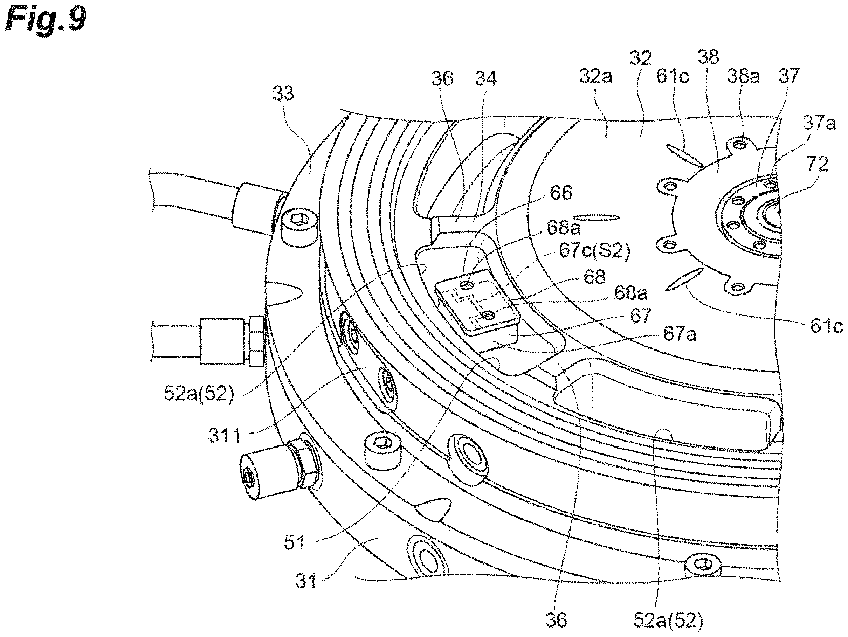

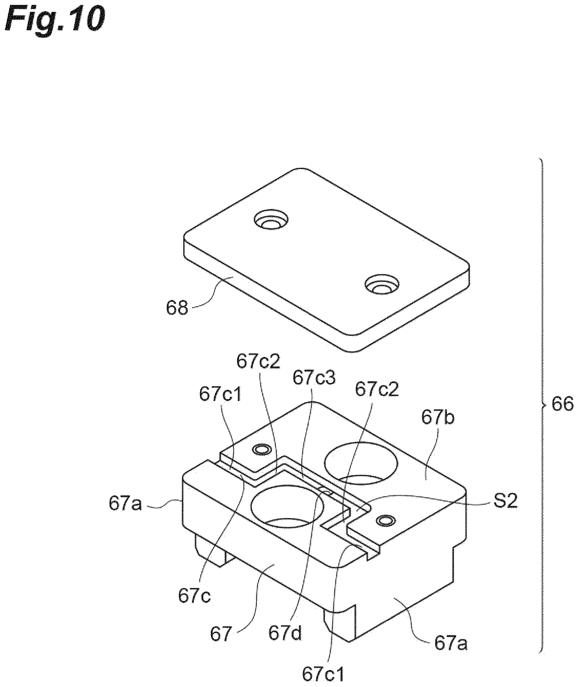

The cooling unit 21 will be described with reference to FIGS. 2 to 10. The cooling unit 21 is disposed to face the semiconductor device 2, and defines a space (gap) S1 between the cooling unit 21 and the semiconductor device 2. In the semiconductor testing device 1, a cooling fluid 5 is caused to flow into the space S1 to cool down the semiconductor device 2. The cooling fluid 5 is, for example, water or pure water, but may be a Fluorinert (registered trademark)-based liquid having an electrical insulating property.

The cooling unit 21 is disposed to be in contact with the stage 3 on which the semiconductor device 2 is disposed (is attached to the stage 3). In this example, the stage 3 includes a DUT board 3a and a holding portion 3b. The DUT board 3a is formed, for example, in a plate shape, and constitutes a connection portion between the signal input device 11 and the semiconductor device 2. The DUT board 3a may be provided with a socket that constitutes the connection portion between the signal input device 11 and the semiconductor device 2. In this example, the semiconductor device 2 includes a package 2b and a die 2c protruding from the package 2b. As an example, the package 2b is a PC board, and the die 2c is a semiconductor portion mounted on (joined onto) the package 2b.

The holding portion 3b is fixed to the DUT board 3a, and holds the semiconductor device 2. The holding portion 3b is formed, for example, in a plate shape with a metal. The holding portion 3b is provided with an opening 3c in which the semiconductor device 2 is disposed. The holding portion 3b includes a locking portion 3d that is in contact with an edge portion of the package of the semiconductor device 2 and is locked to the semiconductor device 2 so that the semiconductor device 2 is not detached from the opening 3c.

The cooling unit 21 includes a jacket 31 configured to dissipate heat of the semiconductor device 2. For example, the jacket 31 is formed in an approximately bottomed cylindrical shape with a metal material. The jacket 31 is disposed to face the semiconductor device 2 and the holding portion 3b. The objective lens 16 is disposed in this jacket 31.

Hereinafter, description will be given on the assumption that a direction parallel to an optical axis L of the objective lens 16 is set as a direction D1. The direction D1 is a direction parallel to the Z-direction described above. In addition, in a state in which the semiconductor device 2 disposed on the stage 3 and the objective lens 16 face each other, a side where the objective lens 16 is located with respect to the semiconductor device 2 is set as a lower side, and a side where the semiconductor device 2 is located with respect to the objective lens 16 is set as an upper side. The cooling unit 21 is used in a state in which the semiconductor device 2 is located on an upper side in a vertical direction with respect to the objective lens 16.

The jacket 31 includes a central portion 32, an outer portion 33, and an intermediate portion 34 when viewed from the direction D1. Hereinafter, description will be given of arrangement, shapes, and the like of respective portions when viewed from the direction D1. The central portion 32 is a portion including the center of the jacket 31, and is a cylindrical portion in this example. The outer portion 33 is a portion located at the periphery of the central portion 32 and surrounds the central portion 32. In this example, the outer portion 33 is an annular portion constituting an outer edge portion (outer peripheral portion) of the jacket 31. The intermediate portion 34 is a portion located between the central portion 32 and the outer portion 33. The intermediate portion 34 is disposed on an inner side of the outer portion 33 and surrounds the central portion 32. In this example, the intermediate portion 34 is an annular portion. Hereinafter, description will be given on the assumption that a side where the central portion 32 is located with respect to the outer portion 33 is set an inner side (an inner side of a radial direction), and a side where the outer portion 33 is located with respect to the central portion 32 is set as an outer side (outer side of the radial direction).

The jacket 31 is formed in an approximately bottomed cylindrical shape as described above, and generally, includes a first member M1 constituting a portion including an upper side bottom, a second member M2 constituting a cylindrical portion, and a third member M3 constituting a portion including a lower side bottom. The first member M1 and the second member M2 are connected to each other, and the second member M2 and the third member M3 are connected to each other to constitute the jacket 31. The central portion 32 is constituted by the first member M1, and each of the outer portion 33 and the intermediate portion 34 is constituted by the first member M1 and the second member M2. The central portion 32 is formed in an approximately plate shape, and the outer portion 33 and the intermediate portion 34 are formed in an approximately annular shape (cylindrical shape) having a thickness larger than that of the central portion 32.

An opening 35 that passes through the central portion 32 along the direction D1 is formed in the central portion 32. The opening 35 has, for example, an approximately circular shape when viewed from the direction D1. The opening 35 is located on the optical axis L, and light from the semiconductor device 2 passes through the opening 35. A solid immersion lens (immersion lens) 72 to which light from the semiconductor device 2 is incident is disposed in the opening 35. Details of the solid immersion lens 72 will be described later.

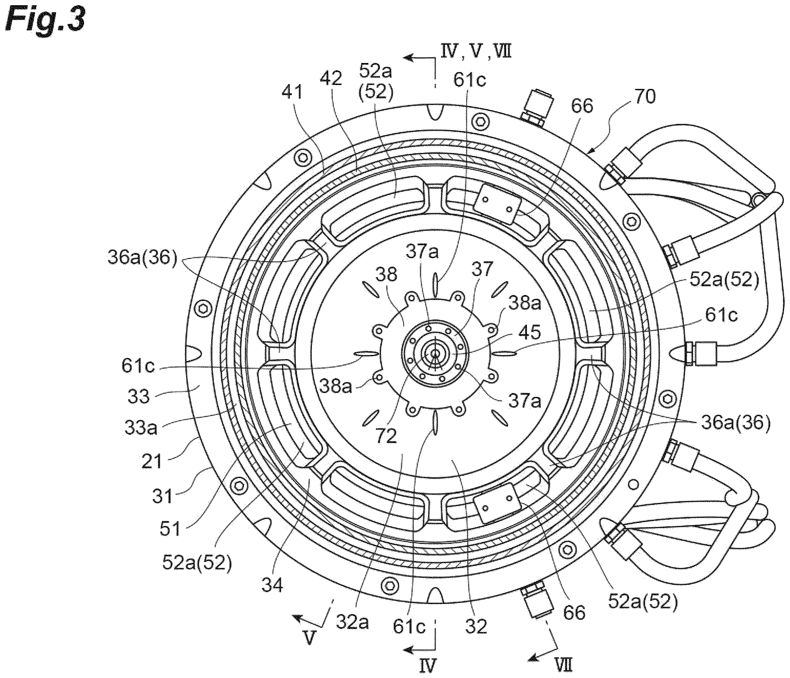

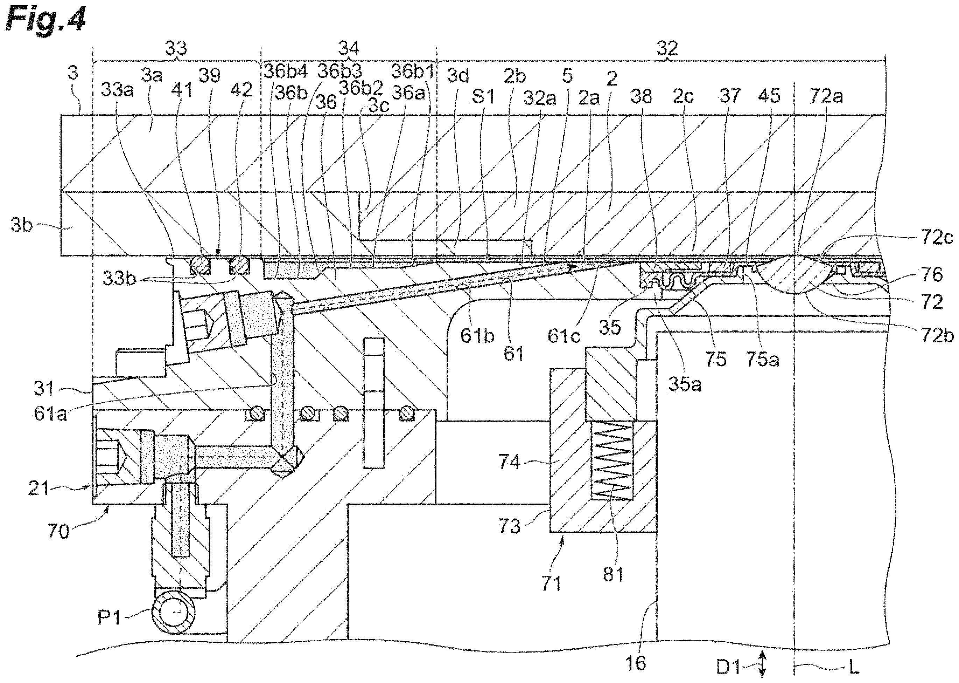

As illustrated in FIGS. 3 and 4, a flexible member 45 and fixing members 37 and 38 are further disposed in the opening 35. For example, the flexible member 45 is formed from a resin such as silicone (for example, a silicone rubber), and has a shape in which a planar member is partially bent into a bellow shape. The flexible member 45 has an opening at a central portion thereof, and the solid immersion lens 72 is disposed in the opening. The flexible member 45 is in contact with a peripheral edge portion of the solid immersion lens 72 in an edge portion of the opening, and according to this, a space between the solid immersion lens 72 and the flexible member 45 is water-tightly sealed. The flexible member 45 is fixed to the central portion 32 by the fixing members 37 and 38. The fixing member 37 is formed in an annular plate shape and is fixed to the flexible member 45 by a fastening member 37a such as a bolt. The fixing member 38 is formed in an annular plate shape, and is disposed to surround the fixing member 37. For example, the fixing member 38 is fixed to the central portion 32 by a fastening member 38a such as a bolt, and sandwiches an outer edge portion of the flexible member 45 with a protruding portion 35a formed in the edge portion of the opening 35. According to this, the flexible member 45 and the central portion 32 are water-tightly sealed.

The central portion 32 includes a space defining surface 32a that faces the semiconductor device 2 and defines the space S1 between the semiconductor device 2 and the cooling unit 21 in a state in which the cooling unit 21 is attached to the stage 3 (the opening 35 faces the semiconductor device 2). The space defining surface 32a is an upper surface of the central portion 32. In this example, the space defining surface 32a is an annular flat surface extending along a plane orthogonal to the direction D1, and faces the semiconductor device 2 and the holding portion 3b. The space defining surface 32a is adjacent to the opening 35 described above and surrounds the opening 35 when viewed from the direction D1. The thickness of the space S1 (a minimum thickness in the direction D1, that is, a distance between the die 2c and the space defining surface 32a in the direction D1) is, for example, approximately from 0.05 mm to 1.0 mm.

The outer portion 33 includes a contact portion 39 that comes into contact with the stage 3 and defines an outer edge portion of the space S1. That is, the contact portion 39 of the outer portion 33 comes into contact with the stage 3, and thus the space S1 is formed. A pair of arrangement grooves 33b in which elastic members 41 and 42 are respectively arranged are formed in an upper surface 33a of the outer portion 33 (FIG. 4). The elastic members 41 and 42 are members which are sandwiched between the jacket 31 and the holding portion 3b to seal the outer edge portion of the space S1, and is, for example, an O-ring. As illustrated in FIG. 3, the elastic members 41 and 42 are formed, for example, in a ring shape. In FIG. 3, the elastic members 41 and 42 are shown by hatching for easy understanding. In this example, the contact portion 39 that comes into contact with the stage 3 and defines the outer edge portion of the space S1 is constituted by the outer portion 33 and the elastic members 41 and 42.

As illustrated in FIG. 3, FIG. 5, and FIG. 6, a groove 51 that is configured so that the cooling fluid 5 flows down from the space defining surface 32a is formed in the intermediate portion 34. The groove 51 includes a first portion 52, and a second portion 53 located on a lower side (side opposite to the space defining surface 32a) with respect to the first portion 52 in the direction D1. The first portion 52 is formed in an approximately ring shape to extend along a peripheral direction when viewed from the direction D1, but is partitioned into a plurality of portions 52a by a plurality of (eight in this example) bridge portions 36. That is, the first portion 52 includes a plurality of portions 52a (pocket portions) separated by the adjacent bridge portions 36. Each of the portions 52a has an approximately annular fan shape when viewed from the direction D1. The bridge portions 36 connect the central portion 32 and the outer portion 33 to each other. The plurality of bridge portions 36 are arranged at regular intervals in the peripheral direction. Each of the bridge portions 36 is constituted by a wall portion extending along a radial direction.

As illustrated in FIG. 4, an upper surface 36a of the bridge portion 36 includes a portion 36b located at a lower position as compared with the space defining surface 32a. The upper surface 36a is a surface that is connected to the space defining surface 32a in the bridge portion 36. In this example, a concave portion is formed in the upper surface 36a and thus the portion 36b is formed. The portion 36b includes an inclined surface 36b1 connected to an outer edge of the space defining surface 32a, a flat surface 36b2 connected to an outer edge of the inclined surface 36b1, an inclined surface 36b3 connected to an outer edge of the flat surface 36b2, and a flat surface 36b4 connected to an outer edge of the inclined surface 36b3. The inclined surfaces 36b1 and 36b3 are inclined outward as going toward a lower side. An inclination angle of the inclined surface 36b3 with respect to a plane parallel to the space defining surface 32a is larger than an inclination angle of the inclined surface 36b1 with respect to the plane. The flat surface 36b4 constitutes a bottom surface of the concave portion, and is located on a lower side as compared with the flat surface 36b2. The flat surface 36b4 is adjacent to the outer portion 33 when viewed from the direction D1. The flat surface 36b4 is located at a lower position as compared with the upper surface 33a of the outer portion 33, and according to this, a step portion is formed between the bridge portion 36 and the outer portion 33.

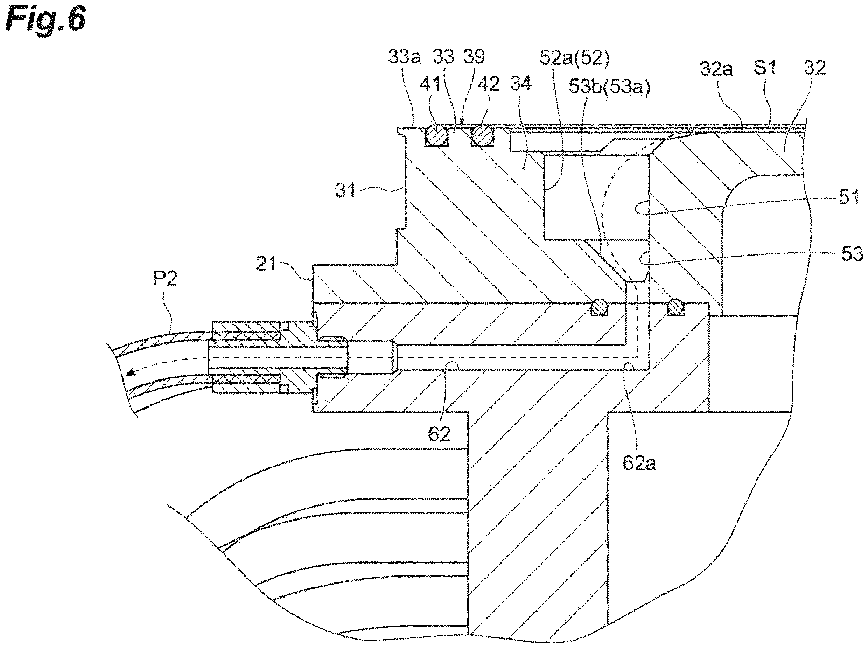

As illustrated in FIG. 6, the second portion 53 is connected to a lower end of the first portion 52. The second portion 53 is formed in a ring shape extending along the peripheral direction when viewed from the direction D1, and surrounds the space defining surface 32a. That is, the second portion 53 is formed to be continuous over the entire periphery different from the first portion 52. The second portion 53 is formed to be narrower than the first portion 52. That is, the groove 51 is narrowed at a boundary portion with the first portion 52 in the second portion 53. In this example, the width of the second portion 53 in the radial direction is set to be narrower than the width of the first portion 52 in the radial direction, and thus the second portion 53 is formed to be narrower than the first portion 52.

An inner surface 53a of the second portion 53 includes an inclined surface 53b inclined inward as going toward a lower side. The inner surface 53a is an inner surface of an outer side in the radial direction in the second portion 53, and constitutes a part of an inner surface of an outer side in the radial direction in the groove 51. The inclined surface 53b is formed at a boundary portion with the first portion 52 in the inner surface 53a, and is connected to the first portion 52 at an upper end. In the peripheral direction, the inclined surface 53b is formed over the entire periphery.

A space inside the groove 51 is connected to the space S1 defined between the space defining surface 32a and the semiconductor device 2. Alternatively, the space inside the groove 51 can be regarded to constitute a part of the space S1. The groove 51 extends from the space defining surface 32a to a lower side. Therefore, the cooling fluid 5 flowing through the space S1 flows down from the space defining surface 32a to the groove 51. That is, the cooling fluid 5 falls down due to gravidity, and moves from an upper side of the space defining surface 32a into the groove 51. For example, the cooling fluid 5 that has flowed down into the groove 51 moves from the first portion 52 to the second portion 53 along the inclined surface 53b, and is stored in the second portion 53. The cooling fluid 5 stored in the second portion 53 is discharged from a discharge flow passage 62 to be described later.

Four supply flow passages 61 through which the cooling fluid 5 supplied to the space S1 flows, and four discharge flow passages 62 through which the cooling fluid 5 discharged from the space S1 to the outside are formed in the jacket 31. As illustrated in FIGS. 2 and 4, the supply flow passage 61 is opened to the outside of the jacket 31 on a lateral side of the jacket 31, and is opened to the space defining surface 32a of the central portion 32. A pipe P1 through which the cooling fluid 5 supplied from the storage tank 22 flows is connected to the opening on the lateral side of the jacket 31.

As illustrated in FIG. 4, the supply flow passage 61 includes a first portion 61a and a second portion 61b. The first portion 61a is formed to pass through the outer portion 33, and is opened to the outside of the jacket 31. The second portion 61b is connected to the first portion 61a and is formed to pass through the bridge portions 36, and includes a supply port 61c opened to the space defining surface 32a (FIGS. 3 and 4). The cooling fluid 5 is supplied from the supply port 61c to the space defining surface 32a (space S1). The second portion 61b extends along the radial direction, and is inclined and extends upward as going toward an inner side. The four supply flow passages 61 are arranged to be lined up at regular intervals in the peripheral direction. In this example, the four supply flow passages 61 are formed at positions corresponding to four of the eight bridge portions 36. The cooling fluid 5 supplied from the supply flow passages 61 to the space S1 flows through the space S1 toward the solid immersion lens 72 (opening 35). In FIG. 4, an example of a route along which the cooling fluid 5 is supplied through the supply flow passages 61 is indicated by a broken arrow.

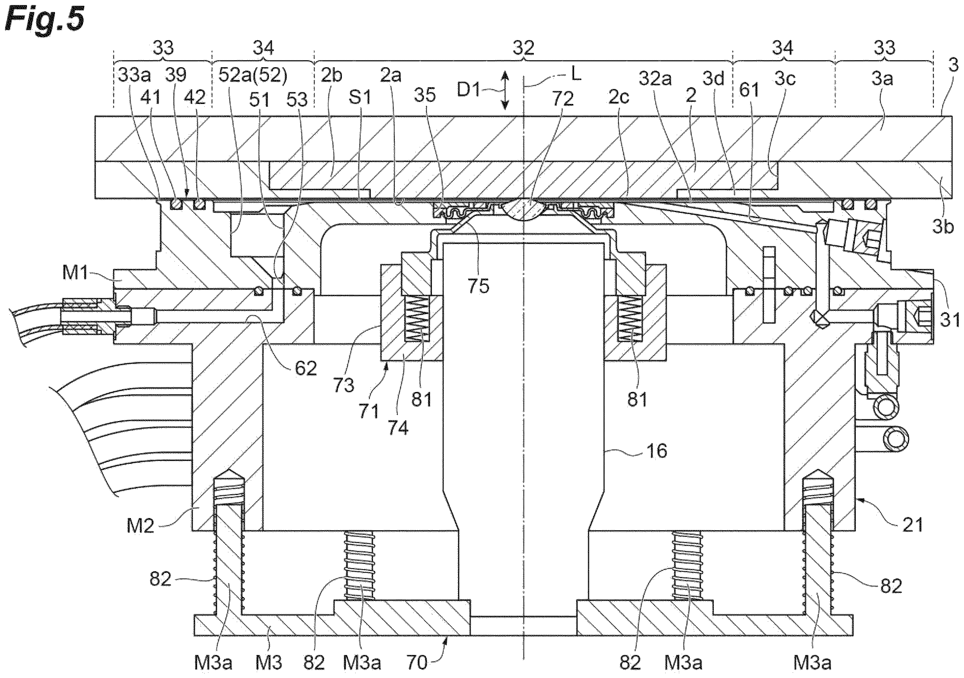

As illustrated in FIGS. 5 and 6, the discharge flow passage 62 is formed to pass through the outer portion 33, and is opened to the outside of the jacket 31 on a lateral side of the jacket 31 and is opened to the second portion 53 of the groove 51. A pipe P2 through which the cooling fluid 5 discharged to the drain tank 24 flows is connected to the opening on the lateral side of the jacket 31. The discharge flow passage 62 includes a discharge port 62a opened to the bottom of the second portion 53, and is connected to the second portion 53 in the discharge port 62a. The cooling fluid 5 is discharged from the second portion 53 through the discharge port 62a. The four discharge flow passages 62 may be disposed at any positions. In this example, each of the discharge flow passages 62 is disposed to be located between two bridge portions 36 adjacent in the peripheral direction. In FIG. 6, an example of a route along which the cooling fluid 5 is discharged through the groove 51 and the discharge flow passages 62 is shown by a broken arrow.

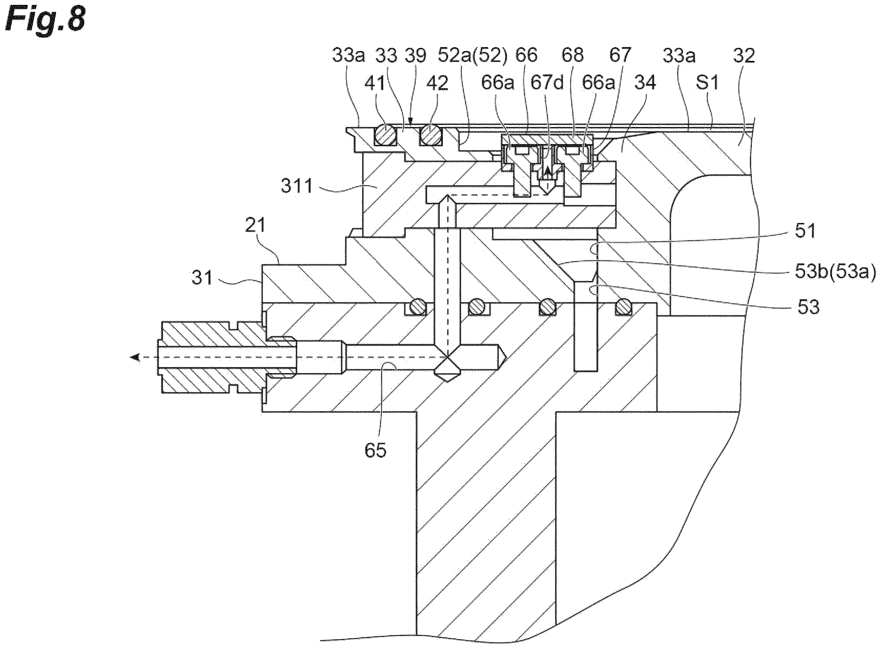

Furthermore, a ventilation route 65 is formed in the jacket 31 to connect the space S1 to the outside of the jacket 31 so that air can circulate between the space S1 (inner side of the outer portion 33) and the outside of the jacket 31 (structure open to the air). As illustrated in FIGS. 8 to 10, the ventilation route 65 is opened to the outside of the jacket 31 on a lateral side of the jacket 31, and is opened to the groove 51 through the ventilation member 66. The opening on the lateral side of the jacket 31 is opened (not closed).

The ventilation member 66 is disposed in the first portion 52 of the groove 51. The ventilation member 66 includes a main body portion 67 and a cover 68. The main body portion 67 is formed in an approximately rectangular parallelepiped shape, and includes a pair of side surfaces 67a facing each other. A groove 67c is formed in a surface 67b of the main body portion 67. The surface 67b is a surface covered with the cover 68. The groove 67c extends from one side surface 67a to the other side surface 67a. In this example, the groove 67c includes a pair of linear portion 67c1 extending from the side surfaces 67a, a pair of linear portions 67c2 extending orthogonally to the linear portions 67c1 from the pair of linear portions 67c1, and a linear portion 67c3 extending in parallel to the linear portion 67c1 so as to connect the pair of linear portions 67c2.

When an upper portion of the groove 67c is covered with the cover 68, an internal space S2 having a shape corresponding to the groove 67c is defined. A through-hole 67d passing through the main body portion 67 is formed in the linear portion 67c3 of the groove 67c. The internal space S2 (groove 67c) is connected to the ventilation route 65 through the through-hole 67d. In addition, the groove 67c is set to reach the respective side surfaces 67a, and thus the internal space S2 is opened from the respective side surfaces 67a and is connected to the first portion 52 of the groove 51. In this example, the cover 68 is disposed on the main body portion 67 to protrude from the respective side surfaces 67a. That is, a length of the cover 68 in a direction orthogonal to the side surfaces 67a is longer than a length of the main body portion 67 in the direction (distance between the pair of side surfaces 67a), and the cover 68 protrudes from the respective side surfaces 67a in the direction. According to this, the cooling fluid 5 that flows down to the groove 51 from the space defining surface 32a is suppressed from intruding into the internal space S2. The cover 68 is located vertically above the main body portion 67.

For example, the cover 68 is fixed to the main body portion 67 by a fastening member 68a such as a bolt. For example, the ventilation member 66 is fixed to the jacket 31 by a fastening member 66a such as a bolt. In this example, the jacket 31 includes a fixing portion 311 formed to protrude to the first portion 52 of the groove 51 from the outer portion 33, and the ventilation member 66 is fixed to the fixing portion 311. The ventilation route 65 is formed to pass through the inside of the fixing portion 311. In FIG. 8, an example of a route along which air flows between the space S1 and the outside of the jacket 31 through the ventilation route 65 and the ventilation member 66 is shown by a broken arrow. As described above, the opening of the ventilation route 65 on the lateral side of the jacket 31 is opened, and the ventilation route 65 is always opened. That is, in the cooling unit 21, air can circulate always between the space S1 and the outside of the jacket 31 (the space S1 is not closed).

A route along which the cooling fluid 5 flows will be described with reference to FIG. 1 again. The cooling fluid 5 is stored in the storage tank 22. The cooling fluid 5 inside the storage tank 22 is pressurized by a compressor (not illustrated) and is supplied to the supply flow passages 61 through the regulators 23. Each of the four regulators 23 is connected to each of the supply flow passages 61 through the pipe P1. Each of the regulator 23 is controlled by the control unit 15 and changes a pressure of a fluid flowing through the supply flow passage 61. According to this, a pressure of the cooling fluid 5 flowing through the space S1 is adjusted. The cooling fluid 5 discharged from the discharge flow passage 62 is stored in the drain tank 24. The chiller 25 cools down the cooling fluid 5 to a predetermined setting temperature. The cooling fluid 5 discharged from the discharge flow passage 62 flows into the chiller 25. The chiller 25 cools down the cooling fluid 5 that has flowed in. The cooling fluid 5 that has been cooled down by the chiller 25 is returned to the storage tank 22 and is supplied to the supply flow passage 61 again. The jacket 31 may be cooled down by causing a coolant to flow through a coolant flow passage formed in the jacket 31. In this case, the coolant may be, for example, water or air. That is, the jacket 31 may be cooled down by liquid cooling or air cooling.

### [Objective Lens Module]

As illustrated in FIGS. 2 and 4, the cooling unit 21 constitutes the objective lens module 70 in combination with the objective lens 16. The objective lens module 70 includes a solid immersion lens unit (immersion lens unit) 71 that is attached to the objective lens 16 in addition to the above-described cooling unit 21 and the objective lens 16. The solid immersion lens unit 71 includes a solid immersion lens 72 and a holder 73. The objective lens 16 is disposed to face the semiconductor device 2 through the opening 35 of the jacket 31. The solid immersion lens 72 is held inside the opening 35 by the holder 73 and is located on the optical axis L of the objective lens 16.

The solid immersion lens 72 includes a contact surface 72a, a spherical surface 72b, and a tapered surface 72c. The contact surface 72a is a flat surface and comes into contact with the die 2c of the semiconductor device 2. The spherical surface 72b is a hemispherical surface that is convex downward and faces the objective lens 16. The tapered surface 72c is a surface having a truncated conical shape that widens downward, extends downward from an outer edge of the contact surface 72a, and is connected to an outer edge of the spherical surface 72b. The apex of a virtual cone including the tapered surface 72c matches a spherical center of the solid immersion lens 72 (the center of curvature of the spherical surface 72b), and is located on the optical axis L of the objective lens 16 on an upper side of the contact surface 72a. The spherical center of the solid immersion lens 72 matches a focal point of the solid immersion lens 72. The solid immersion lens 72 may further include a conical surface disposed between the spherical surface 72b and the tapered surface 72c. Note that, another immersion lens such as a liquid immersion lens or an oil immersion lens may be used in addition to the solid immersion lens.

The solid immersion lens 72 is formed from a high refractive index material having a refractive index that is substantially the same as or close to that of a substrate material of the semiconductor device 2. Representative examples thereof include Si, GaP, GaAs, and the like. The solid immersion lens 72 allows observation light to be transmitted therethrough. When, the solid immersion lens 72 is brought into optically close contact with the semiconductor device 2, the semiconductor device 2 itself can be used as a part of the solid immersion lens 72. According to a rear surface analysis of the semiconductor device 2 using the solid immersion lens 72, when focusing the focal point of the objective lens 16 to an integrated circuit formed on a substrate surface of the semiconductor device 2, a luminous flux with a high numerical aperture (NA) can be transmitted through the semiconductor device 2 due to an effect of the solid immersion lens 72, and high resolution can be realized.

The holder 73 is attached to the objective lens 16, and holds the solid immersion lens 72 in combination with the above-described flexible member 45. The holder 73 includes a side wall portion 74 and a lid portion 75. The holder 73 is formed from a non-magnetic material (for example, aluminum, an aluminum alloy, a non-magnetic stainless steel, or the like). The side wall portion 74 is formed in an approximately tubular shape. The lid portion 75 is configured to close an upper opening of the side wall portion 74.

An opening 75a in which the solid immersion lens 72 is disposed is formed in the lid portion 75. The lid portion 75 includes a plurality of (for example, three) protruding portions 76 extending toward a center side of the opening 75a from an inner surface of the opening 75a. The protruding portions 76 has a tapered shape, and a surface on the semiconductor device 2 side is an inclined surface that is inclined so as to approach the objective lens 16 as approaching the center of the opening 75a. For example, the plurality of protruding portions 76 are arranged at regular intervals in the peripheral direction.

The solid immersion lens 72 is disposed in the opening 75a so that the contact surface 72a and the tapered surface 72c protrude upward from the opening 75a of the lid portion 75 and the spherical surface 72b protrudes downward from the opening 75a of the lid portion 75. The spherical surface 72b is in contact with a tip end portion of each of the protruding portions 76, and the contact surface 72a and the tapered surface 72c are in contact with the flexible member 45 and protrude upward from the flexible member 45. The solid immersion lens 72 can swing in a state before the contact surface 72a comes into contact with the semiconductor device 2. For example, when the solid immersion lens 72 swings, the spherical surface 72b slides against the tip end portion of the protruding portion 76, and the flexible member 45 is deformed in conformity to the swing of the solid immersion lens 72. Since the solid immersion lens 72 can swing, when the contact surface 72a is brought into contact with the semiconductor device 2, the solid immersion lens 72 is likely to be brought into close contact with the semiconductor device 2. As a result, for example, even in a case where the semiconductor device 2 is disposed to be inclined to the optical axis L, the solid immersion lens 72 can be brought into close contact with the semiconductor device 2 in a satisfactory manner, and the semiconductor device 2 can be observed.

A plurality of (two in this example) first biasing members 81 configured to bias the solid immersion lens 72 upward (to a side opposite to the objective lens 16) by pressing the lid portion 75 upward are provided between the side wall portion 74 and the lid portion 75 in the holder 73. For example, the first biasing members 81 are constituted by a spring held in the side wall portion 74.

A plurality of (four in this example) second biasing members 82 configured to bias the jacket 31 toward the stage 3 (toward an upper side) by pressing the second member M2 upward are provided between the second member M2 and the third member M3 in the jacket 31. For example, the second biasing members 82 are constituted by a spring held by a guide portion M3a. The guide portion M3a is a conical portion that is provided in the third member M3 and extends along the direction D1. The second biasing members 82 are provided separately and independently from the first biasing members 81, and a biasing force of the second biasing members 82 does not act on the solid immersion lens 72 (the objective lens 16 and the solid immersion lens unit 71). A lower portion of the objective lens 16 is held by the third member M3.

### [Semiconductor Test Method]

In a semiconductor test method using the semiconductor testing device 1, first, the semiconductor device 2 is disposed on (fixed to) the stage 3 (first step). Next, the cooling unit 21 is disposed so that the opening 35 faces the semiconductor device 2, and the space S1 is defined between the space defining surface 32a and the semiconductor device 2 (second step). More specifically, for example, the objective lens module 70 is moved by the above-described XYZ stage, and the cooling unit 21 is attached to the stage 3 so that the opening 35 faces the semiconductor device 2. According to this, the space S1 is formed between the cooling unit 21, the semiconductor device 2, and the stage 3. In the second step, the contact portion 39 including the outer portion 33 and the elastic members 41 and 42 comes into contact with the stage 3 and thus an outer edge portion of the space S1 is defined.

Next, the solid immersion lens 72 is moved to be close to the semiconductor device 2 by moving the objective lens 16 by the XYZ stage, and the contact surface 72a of the solid immersion lens 72 is brought into contact with the semiconductor device 2 (third step). Next, the semiconductor device 2 is driven by the signal input device 11 (fourth step). Next, light coming from the semiconductor device 2 that is being driven and passing through the opening 35 is detected by the photodetector 14 while flowing the cooling fluid 5 into the space S1 (fifth step). Through the above-described processes, the semiconductor device 2 can be tested. Note that, the fourth step of driving the semiconductor device 2 may be performed before the second step or the third step.

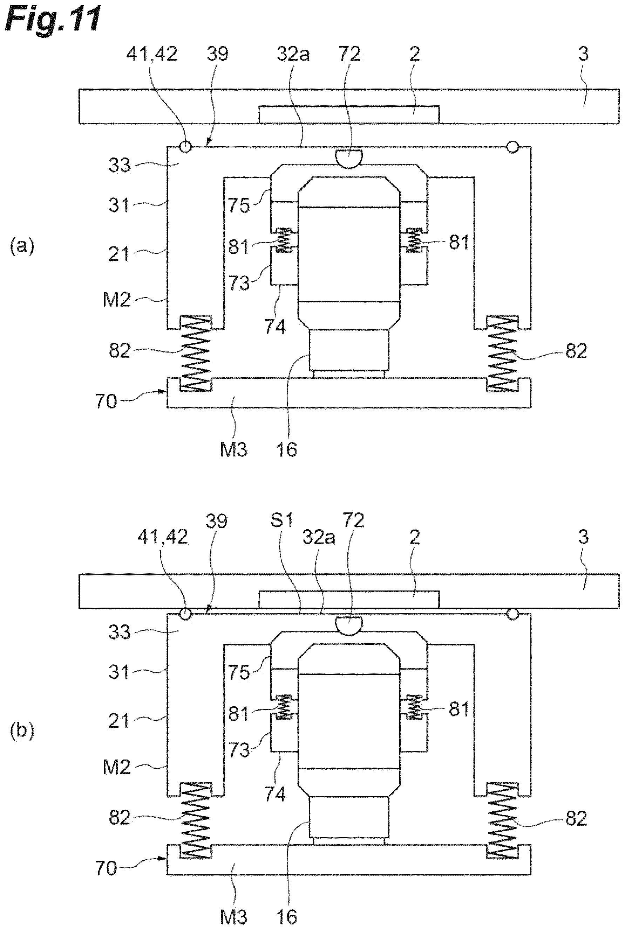

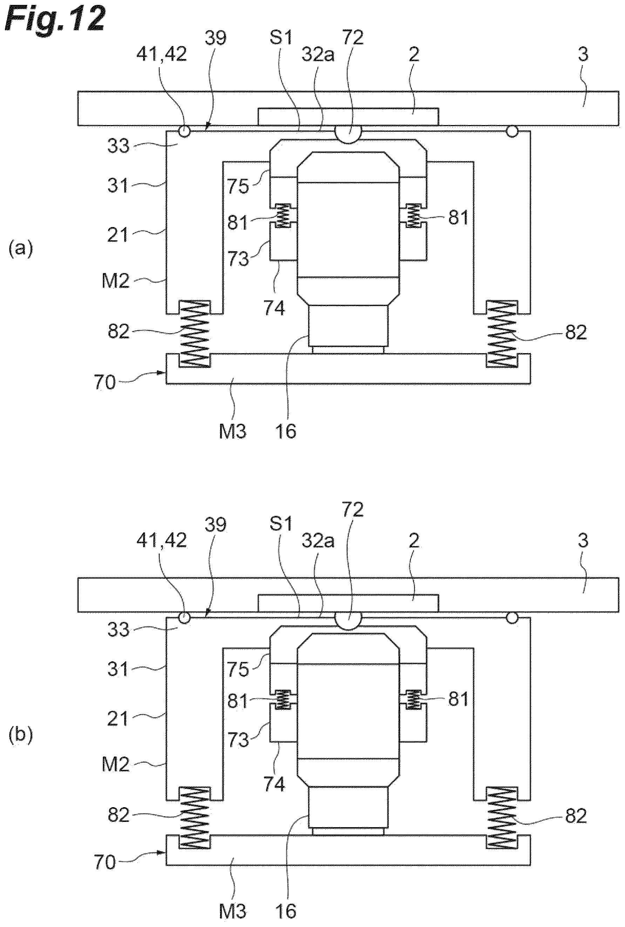

The semiconductor test method using the semiconductor testing device 1 will be further described with reference to FIGS. 11 and 12. In FIGS. 11 and 12, respective configurations are schematically illustrated. As described above, first, the semiconductor device 2 is disposed on (fixed to) the stage 3 (first step, FIG. 11(a)). Next, the XYZ stage is raised to move the objective lens module 70 upward, and the contact portion 39 including the outer portion 33 and the elastic members 41 and 42 is brought into contact with the stage 3. According to this, the space S1 is formed between the cooling unit 21, the semiconductor device 2, and the stage 3 (second step, FIG. 11(b)). The contact between the contact portion 39 and the stage 3 is detected, for example, by a first sensor (not illustrated) provided in the jacket 31. In the second step, the control unit 15 controls the XYZ stage on the basis of a detection result of the first sensor. For example, the first sensor can be constituted by a photosensor that is turned on and off by blocking light.

Next, the XYZ stage is further raised. At this time, since the cooling unit 21 is in contact with the stage 3 at the contact portion 39, the cooling unit 21 cannot be moved, and the second biasing member 82 provided between the second member M2 and the third member M3 in the jacket 31 is shrunk. On the other hand, the objective lens 16 and the solid immersion lens 72 are raised in accordance with movement of the XYZ stage, and the solid immersion lens 72 comes into contact with the semiconductor device 2 (third step, FIG. 12(a)). The contact between the solid immersion lens 72 and the semiconductor device 2 is detected, for example, by a second sensor (not illustrated) provided in the holder 73. In the third step, the control unit 15 controls the XYZ stage on the basis of a detection result of the second sensor. For example, the second sensor can be constituted by a photosensor that is turned on and off by blocking light. Arrangement of the photosensor is not particularly limited. For example, the photosensor may be provided in the side wall portion 74, and a dog member blocking light of the photosensor may be provided in the lid portion 75. Alternatively, the photosensor may be provided in the lid portion 75, and the dog member may be provided in the side wall portion 74. This is also true of a case of constituting a third sensor by the photosensor to be described later.

An adjustment step of adjusting a focal position by further raising the XYZ stage may be performed after the third step and before the fourth step of driving the semiconductor device 2 (FIG. 12(b)). In the adjustment step, even in a case of raising the XYZ stage, since the cooling unit 21 is in contact with the stage 3 in the contact portion 39, the cooling unit 21 cannot be moved, and the second biasing member 82 is shrunk. In addition, since the solid immersion lens 72 is in contact with the semiconductor device 2, the solid immersion lens 72 cannot be moved, and the objective lens 16 is raised in accordance with movement of the XYZ stage. At this time, the first biasing member 81 provided between the side wall portion 74 and the lid portion 75 in the holder 73 is shrunk. The third sensor (not illustrated) for preventing the XYZ stage (the objective lens 16) from overrunning is provided in the holder 73. For example, the third sensor detects that the XYZ stage has been raised up to a predetermined position. The predetermined position is a position corresponding to a position where a device is damaged due to rising of the XYZ stage. In the adjustment step, the control unit 15 controls the XYZ stage on the basis of a detection result of the third sensor. According to this, it is possible to suppress the device from being damaged due to excessive rising of the XYZ stage. For example, the third sensor can be constituted by a photosensor that is turned on and off by blocking light.

Next, as described above, the semiconductor device 2 is driven by the signal input device 11 (fourth step), light from the semiconductor device 2 that is being driven is detected by the photodetector 14 while flowing the cooling fluid 5 into the space S1 (fifth step). According to this, the semiconductor device 2 can be tested.

Next, description will be given of an example of a process of changing an observation area (test position) on the semiconductor device 2. In the semiconductor testing device 1 according to the embodiment, the observation area can be changed while flowing the cooling fluid 5 into the space S1. That is, it is possible to change the observation area while driving the semiconductor device 2 and maintaining cooling performance. When changing the observation area, first, for example, the XYZ stage is lowered from a state illustrated in FIG. 12(a) or FIG. 12(b) to separate the solid immersion lens 72 from the semiconductor device 2 (FIG. 11(b)). The reason for this is as follows. When the objective lens module 70 is moved in the X-direction and/or the Y-direction in a state in which the solid immersion lens 72 is in close contact with the semiconductor device 2, there is a concern that the solid immersion lens 72 or the semiconductor device 2 may be damaged. For example, the control unit 15 lowers the XYZ stage up to a position where the second sensor is turned off, thereby separating the solid immersion lens 72 from the semiconductor device 2. At this time, the contact portion 39 of the cooling unit 21 is in contact with the stage 3, and the space S1 is formed between the cooling unit 21, the semiconductor device 2, and the stage 3. In addition, supply of the cooling fluid 5 to the space S1 is continued. Next, the objective lens module 70 is moved in the X-direction and/or the Y-direction with respect to the stage 3 by the XYZ stage to move the solid immersion lens 72 to a position corresponding to a desired observation area. Next, the XYZ stage is raised to raise the objective lens 16 and the solid immersion lens 72, and bring the solid immersion lens 72 into contact with the semiconductor device. Through the above-described processes, it is possible to change the observation area while flowing the cooling fluid 5 into the space S1.

### [Function and Effect]

In the cooling unit 21, the groove 51 configured so that the cooling fluid 5 flows from the space defining surface 32a (an upper surface of the central portion 32) is formed between the central portion 32 and the outer portion 33 in the jacket 31, and the discharge flow passage 62 through which the cooling fluid 5 to be discharged to the outside passes is connected to the groove 51. According to this, in a case of cooling the semiconductor device 2 by flowing the cooling fluid 5 from the supply flow passage 61 to the space S1 formed when the contact portion 39 of the outer portion 33 comes into contact with the stage 3, it is possible to suppress the cooling fluid 5 from reaching the outer edge portion of the space S1 (a location where the outer portion 33 of the jacket 31 and the stage 3 come into contact with each other). As a result, it is possible to suppress the cooling fluid 5 from being leaked from the outer edge portion of the space S1, and it is possible to improve the waterproof performance. In addition, when the groove 51 is formed, it is possible to suppress the space S1 from being filled with the cooling fluid 5, and according to this, it is possible to improve the waterproof performance. In addition, since the cooling fluid 5 is suppressed from reaching the outer edge portion of the space S1, the elastic members 41 and 42 for sealing the outer edge portion can be omitted or simplified. For example, the elastic members 41 and 42 may be replaced with a flexible member.

The bridge portion 36 that connects the central portion 32 and the outer portion 33 is formed between the central portion 32 and the outer portion 33 in the jacket 31 (in the intermediate portion 34), and the supply flow passage 61 is formed to pass through the bridge portion 36. According to this, the supply flow passage 61 can be appropriately formed. For example, the configuration of the supply flow passage 61 can be further simplified as compared with a case where the supply flow passage 61 is formed so as to go around the groove 51 without passing through the bridge portion 36.

The upper surface 36a of the bridge portion 36 (the surface connected to the space defining surface 32a) includes a portion 36b located at a position lower than the space defining surface 32a. According to this, it is possible to suppress the cooling fluid 5 from reaching the outer edge portion of the space S1 from the space defining surface 32a along the upper surface 36a.

The groove 51 includes the first portion 52 and the second portion 53 located on a side opposite to the space defining surface 32a with respect to the first portion 52 in the direction D1 (direction orthogonal to the space defining surface 32a), the second portion 53 is formed to be narrower than the first portion 52, and the discharge flow passage 62 is connected to the second portion 53. According to this, the opening area of the groove 51 can be increased by forming the first portion 52 located on the space defining surface 32a side to be wide, and the cooling fluid 5 is likely to flow into the groove 51. In addition, the second portion 53 located on a side opposite to the space defining surface 32a is formed to be narrow, and thus the cooling fluid 5 is likely to be stored in the second portion 53. As a result, it is possible to efficiently discharge the cooling fluid 5 from the discharge flow passage 62 connected to the second portion 53.

The inner surface 53a on an outer side in the groove 51 includes the inclined surface 53b inclined inward as going toward a lower side. According to this, the volume of the groove 51 can be increased, and the cooling fluid 5 flowing into the groove 51 can be appropriately allowed to flow to the lower side.

The groove 51 includes the ring-shaped second portion 53 that surrounds the space defining surface 32a when viewed from the direction D1. According to this, it is possible to efficiently store the cooling fluid 5 in the groove 51, and it is possible to efficiently discharge the stored cooling fluid 5 to the outside.

The ventilation route 65 that connects the space S1 to the outside of the jacket 31 so that air circulation between the space S1 and the outside of the jacket 31 becomes possible is formed in the jacket 31, and the ventilation route 65 is connected to the groove 51. According to this, it is possible to suppress a pressure inside the space S1 from being a negative pressure. Therefore, when moving the cooling unit 21 along the stage 3 on which the semiconductor device 2 is disposed while flowing the cooling fluid 5, it is possible to suppress occurrence of a situation in which the cooling unit 21 sticks to the stage 3 due to the negative pressure, and thus the cooling unit 21 cannot be moved, and movement accuracy deteriorates. As a result, it is possible to move the cooling unit 21 with accuracy while flowing the cooling fluid 5.

The groove 51 is formed between the central portion 32 and the outer portion 33 (intermediate portion 34) in the jacket 31, and the ventilation route 65 is connected to the groove 51. According to this, since the groove 51 is less likely to be filled with the cooling fluid 5, it is possible to ensure air circulation between the space S1 and the outside of the jacket 31 through the ventilation route 65.

The ventilation route 65 is connected to the groove 51 through a ventilation member 66 disposed in the groove 51. According to this, it is possible to suppress the cooling fluid 5 from intruding into the ventilation route 65.

The ventilation member 66 has the inner space S2 connected to the ventilation route 65, and the inner space S2 may be opened in the side surface 67a of the ventilation member 66 to be connected to the groove 51. According to this, it is possible to effectively suppress the cooling fluid 5 from intruding into the ventilation route 65 (inner space S2).

The ventilation member 66 includes the main body portion 67 having the side surface 67a, and the cover 68, and the cover 68 is disposed on the main body portion 67 so as to protrude from the side surface 67a. According to this, it is possible to more effectively suppress the cooling fluid 5 from intruding into the ventilation route 65 (inner space S2).

The ventilation route 65 is always opened. According to this, it is possible to reliably suppress the pressure of the space S1 between the space defining surface 32a and the semiconductor device 2 from being a negative pressure.

### [Modification Example]

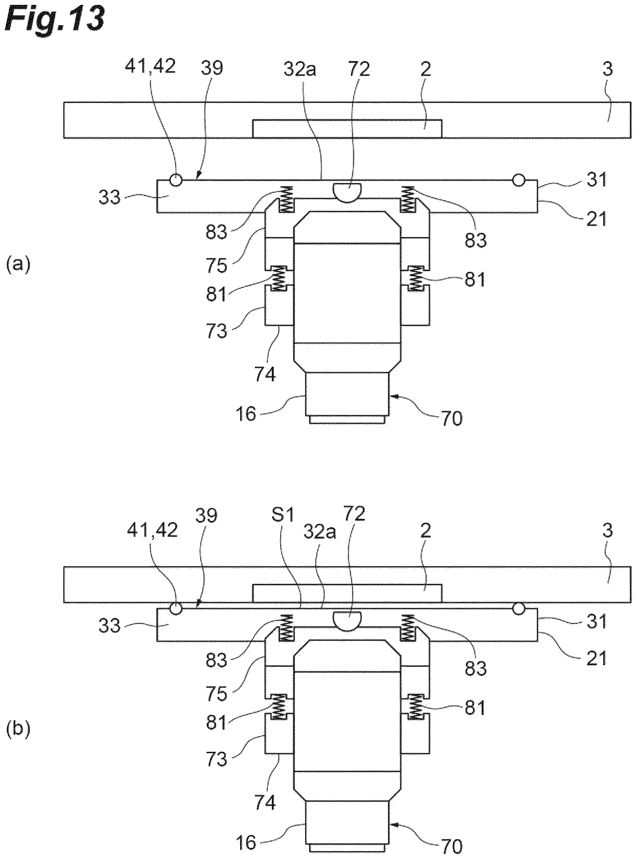

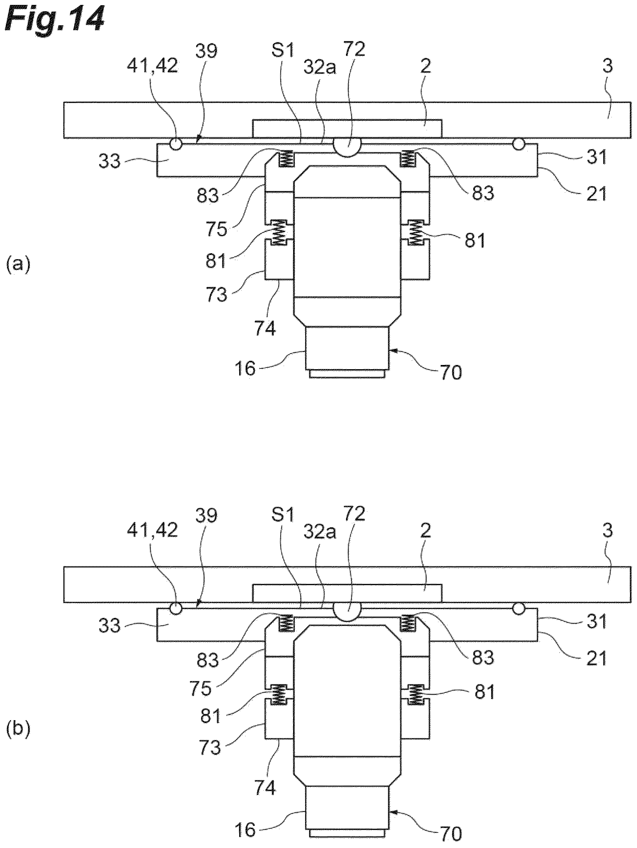

In a cooling unit 21 of a first modification example illustrated in FIGS. 13 and 14, a biasing member 83 that biases the jacket 31 toward the stage 3 (toward an upper side) is provided between the jacket 31 and the holder 73 instead of the second biasing member 82. The second biasing member 82 of the above-described embodiment is provided separately/independently from the first biasing member 81 (in parallel to the first biasing member 81). In contrast, the biasing member 83 of the first modification example is provided in series to the first biasing member 81, and a biasing force of the biasing member 83 acts on the solid immersion lens 72 in the first modification example. A spring constant of the biasing member 83 is smaller than a spring constant of the first biasing member 81. Note that, the spring constant of the biasing member 83 may be set to be larger than the spring constant of the first biasing member 81.

Description will be given of an example of a semiconductor test method using the semiconductor testing device 1 according to the first modification example. First, the semiconductor device 2 is disposed on (fixed to) the stage 3 (first step, FIG. 13(a)). Next, the XYZ stage is raised to move the objective lens module 70 upward, and the contact portion 39 including the outer portion 33 and the elastic members 41 and 42 is brought into contact with the stage 3. According to this, the space S1 is formed between the cooling unit 21, the semiconductor device 2, and the stage 3 (second step, FIG. 13(b)).

Next, the XYZ stage is further raised. At this time, since the cooling unit 21 is in contact with the stage 3 at the contact portion 39, the cooling unit 21 cannot be moved, and the biasing member 83 provided between the jacket 31 and the holder 73 is shrunk. On the other hand, the objective lens 16 and the solid immersion lens 72 are raised in accordance with movement of the XYZ stage, and the solid immersion lens 72 comes into contact with the semiconductor device 2 (third step, FIG. 14(a)). Next, an adjustment step of adjusting a focal position by further raising the XYZ stage can be performed (FIG. 14(b)). In the adjustment step, even in a case of raising the XYZ stage, since the cooling unit 21 is in contact with the stage 3 in the contact portion 39, the cooling unit 21 is not moved. In addition, since the solid immersion lens 72 is in contact with the semiconductor device 2, the solid immersion lens 72 also cannot be moved, and the objective lens 16 is raised in accordance with movement of the XYZ stage. At this time, the biasing member 83 is not shrunk, and the first biasing member 81 provided between the side wall portion 74 and the lid portion 75 in the holder 73 is shrunk. Then, the semiconductor device 2 is driven by the signal input device 11 (fourth step), light from the semiconductor device 2 that is being driven is detected by the photodetector 14 while flowing the cooling fluid 5 into the space S1 (fifth step).

Even in the semiconductor testing device 1 according to the first modification example, it is possible to change the observation area while flowing the cooling fluid 5 into the space S1. A process when changing the observation area is the same as in the above-described embodiment. According to the first modification example, it is also possible to improve waterproof performance as in the above-described embodiment.

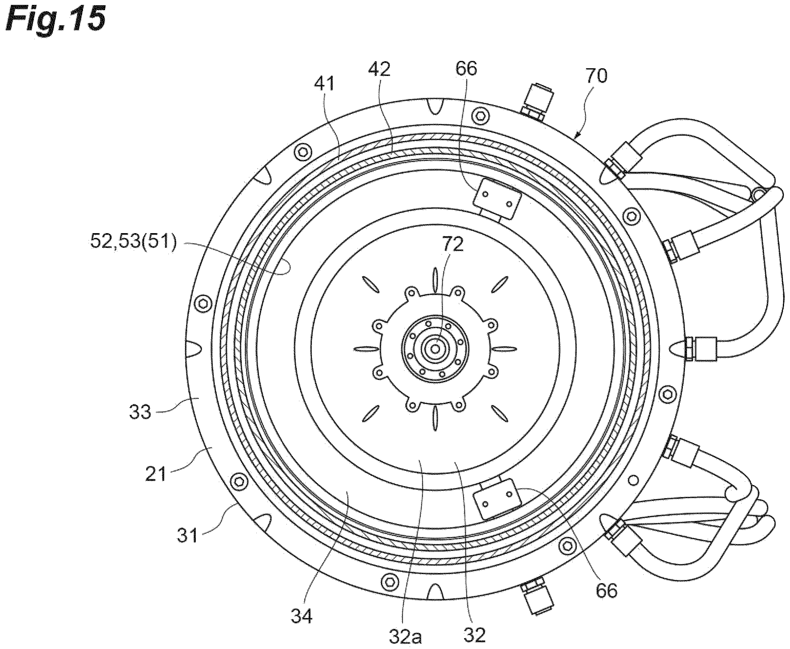

In a second modification example illustrated in FIG. 15, the bridge portion 36 is not formed in the jacket 31, and the first portion 52 of the groove 51 (that is, the entirety of the groove 51) is formed in a ring shape extending along a peripheral direction when viewed from the direction D1. Even according to this second modification example, the waterproof performance can be improved as in the above-described embodiment.

As another modification example, the supply flow passage 61 to which the cooling fluid 5 is supplied may be switchable depending on the observation position on the semiconductor device 2. For example, eight supply flow passages 61 may be arranged to be aligned at constant intervals in the peripheral direction, and the cooling fluid 5 may be supplied from four supply flow passages 61 among the eight supply flow passages 61 in a first state, and the cooling fluid 5 may be supplied from the remaining four supply flow passages 61 among the eight supply flow passages 61 in the second stage. For example, in the first state, the cooling fluid 5 may be supplied to four supply flow passages 61 so that the cooling fluid 5 flows from four directions including both sides in the X-direction and both sides in the Y-direction with respect to the solid immersion lens 72, and in the second state, the cooling fluid 5 may be supplied to the remaining four supply flow passages 61 so that the cooling fluid 5 flows from four directions deviated by 45 degrees from the four directions in the first state with respect to the solid immersion lens 72. Since a heat generation location can vary depending on the observation position on the semiconductor device 2, when using this configuration, effective cooling corresponding to the observation position on the semiconductor device 2 becomes possible. The number of cooling fluids 5 and a switching pattern may be appropriately set.

The present disclosure is not limited to the embodiment and the modification example described above. For example, materials and shapes of the respective configurations are not limited to the materials and the shapes described above, and various materials and shapes can be employed. Only one supply flow passage 61 and/or one discharge flow passage 62 may be provided. The elastic members 41 and 42 may be omitted, or may be replaced with flexible members.

The upper surface 36a of the bridge portion 36 may not include a portion located to be lower than the space defining surface 32a, and for example, the upper surface 36a may be flushed with the space defining surface 32a. The second portion 53 of the groove 51 may not be formed to be narrower than the first portion 52, and may have, for example, approximately the same width as in the first portion 52. The inner surface 53a on an outer side in the groove 51 may not include the inclined surface 53b. The groove 51 may not include the ring-shaped portion surrounding the space defining surface 32a when viewed from the direction D1. The groove 51 may be configured so that the cooling fluid 5 flows down from the space defining surface 32a, and may have any shape and any arrangement. The ventilation route 65 may not formed, and air may not circulate between the space S1 and the outside of the jacket 31.

The ventilation route 65 may connect the space S1 to the outside of the jacket 31 so that air circulation between the space S1 and the outside of the jacket 31 becomes possible, and may not be connected to the groove 51. The ventilation member 66 may be omitted, and the ventilation route 65 may be connected to the groove 51 without through the ventilation member 66.

The semiconductor device 2 is not limited to a device including a logic LSI. The semiconductor device 2 may be an individual semiconductor element (discrete), an optoelectronic element, a sensor/actuator, a memory element, a linear integrated circuit (IC) or the like, a hybrid device thereof, or the like. The individual semiconductor element includes a diode, a power transistor, or the like. The semiconductor device 2 may be a package including a semiconductor device, a composite substrate, or the like. For example, the semiconductor device 2 may be formed by incorporating a plurality of elements (capacitor and the like) into a silicon substrate.

### Reference Signs List

1: semiconductor testing device, 2: semiconductor device, 3: stage, 5: cooling fluid, 14: photodetector, 16: objective lens, 21: cooling unit, 31: jacket, 32: central portion, 32a: space defining surface, 33: outer portion, 35: opening, 36: bridge portion, 36a: upper surface, 36b: portion, 53b: inclined surface, 39: contact portion, 51: groove, 52: first portion, 53: second portion, 53a: inner surface, 53b: inclined surface, 61: supply flow passage, 62: discharge flow passage, 65: ventilation route, 66: ventilation member, 67: main body portion, 67a: side surface, 68: cover, 70: objective lens module, 72: solid immersion lens (immersion lens), S1: space, S2: internal space.

## Claims

1. A cooling unit for using in a semiconductor device test, comprising:
a jacket configured to dissipate heat of the semiconductor device,
wherein the jacket includes a central portion, and an outer portion located around the central portion,
an opening through which light from the semiconductor device passes is formed in the central portion,
the outer portion includes a contact portion that comes into contact with a stage on which the semiconductor device is disposed,
a supply flow passage through which a cooling fluid for cooling the semiconductor device flows is formed in the jacket,
a groove configured so that the cooling fluid flows down from an upper surface of the central portion is formed between the central portion and the outer portion in the jacket, and
a discharge flow passage through which the cooling fluid to be discharged to an outside flows is connected to the groove.

2. The cooling unit according to claim 1,
wherein a bridge portion connecting the central portion and the outer portion to each other is formed between the central portion and the outer portion in the jacket, and
the supply flow passage is formed to pass through the bridge portion.

3. The cooling unit according to claim 1 or 2,
wherein a bridge portion connecting the central portion and the outer portion to each other is formed between the central portion and the outer portion in the jacket, and
a surface connected to the upper surface of the central portion in the bridge portion includes a portion located at a position lower than the upper surface of the central portion.

4. The cooling unit according to any one of claims 1 to 3,
wherein the groove includes a first portion, and a second portion located on a side opposite to the upper surface of the central portion with respect to the first portion in a direction orthogonal to the upper surface of the central portion,
the second portion is formed to be narrower than the first portion, and
the discharge flow passage is connected to the second portion.

5. The cooling unit according to any one of claims 1 to 4,
wherein when a side where the central portion is located with respect to the outer portion is set as an inner side, a side where the outer portion is located with respect to the central portion is set as an outer side, and a side where the groove is located with respect to the upper surface of the central portion is set as a lower side, and
an inner surface of the outer side in the groove includes an inclined surface inclined to face the inner side as going toward the lower side.

6. The cooling unit according to any one of claims 1 to 5,
wherein the groove includes a ring-shaped portion surrounding the upper surface when viewed from a direction orthogonal to the upper surface of the central portion.

7. The cooling unit according to any one of claims 1 to 6,
wherein a ventilation route configured to connect the space to an outside of the jacket so that air circulation between a space formed when the contact portion comes into contact with the stage and the outside of the jacket is possible is formed in the jacket, and
the ventilation route is connected to the groove.

8. An objective lens module, comprising:
the cooling unit according to any one of claims 1 to 7;
an immersion lens disposed in the opening; and
an objective lens facing the immersion lens.

9. A semiconductor test device, comprising:
the cooling unit according to any one of claims 1 to 7;
an immersion lens disposed in the opening;
a stage on which the semiconductor device is disposed;
an objective lens facing the immersion lens; and
a photodetector configured to detect light from the semiconductor device through the immersion lens and the objective lens.
